# EUROPEAN PATENT APPLICATION

(11) **EP 4 711 491 A1**
(43) Date of publication of application: **18.03.2026**
(21) Application number: 24200320.0
(22) Date of filing: 13.09.2024
(51) Int. Cl.: C23C 16/30, B05D 1/00, C23C 16/452, C23C 16/513, H01M 4/1395, C23C 8/28, C23C 8/36

(54) **METHOD FOR APPLYING A PROTECTIVE LAYER TO A METAL OR METAL ALLOY SURFACE, AND ARTICLE COMPRISING SUCH PROTECTIVE LAYER**

(71) Applicant: VITO NV, 2400 Mol (BE)
(72) Inventor: RANGASAMY, Vijay Shankar, 2400 Mol (BE); VANGENEUGDEN, Dirk, 2400 Mol (BE)
(74) Representative: AWA Benelux

(57) **Abstract**

The present invention relates to a method for applying a protective layer to a surface of a substrate, the surface comprising a metallic element or an alloy thereof, in particular wherein the metallic element is an alkali metal or an alkaline earth metal. The present invention is further related to an article comprising such a substrate and a protective layer arranged on or covering at least part of the substrate. The invention is further related to an electrode comprising the article, in particular an anode, and to a battery (cell) comprising the electrode.

## Description

### Technical field

The present invention relates to a method for forming a protective layer to at least a part of a surface of a substrate, the surface comprising a metallic element or an alloy thereof, in particular wherein the metallic element is an alkali metal or an alkaline earth metal. The present invention is further related to an article comprising such a substrate and a protective layer arranged on or covering at least part of the substrate. The invention is further related to an electrode comprising the article, in particular an anode, and to a battery (cell) comprising the electrode.

### Background art

Recently, there has been a fast-growing interest in high energy density batteries and battery cells comprising alkali metal anodes and alkaline earth metal anodes. In particular, lithium (Li) but also sodium (Na) as alkali metal and magnesium (Mg) as alkaline earth metal have gained interest as electrode material for anodes, and post-Li ion batteries. The interest in lithium is related to the fact that lithium has the lowest reduction potential of any element, allowing lithium-based batteries to have a very high cell potential. Lithium is the third lightest element and has one of the smallest ionic radii of any single charged ion. Further, by using lithium in the anode, the presence of non-electroactive materials in the electrolyte of a battery or battery cell can be reduced, even minimized. These factors allow lithium-based batteries to have high gravimetric and volumetric energy density and power density in comparison to state-of-the-art batteries, for example, batteries comprising intercalation-based anodes, such as carbon anodes or graphite anodes.

Alkali metal anodes, such as lithium metal anodes, and alkaline earth metal anodes, such as magnesium metal anodes, develop surface films when used in non-aqueous electrochemical cells (electrochemical cells, i.e. battery cells, comprising a non-aqueous electrolyte) because of the reaction of the metal with the electrolyte and with materials that move from the cathode to the electrolyte. This surface film is known in the technical field of batteries as the solid electrolyte interphase (SEI) layer.

The SEI-layer is typically conductive to metal ions composing the anode, while mitigating the reactions of the metal with the electrolyte and its components. However, the SEI-layer can also reduce the discharge voltage and the capacity of the cell, and a SEI-layer with reduced effectiveness or efficiency results often in corrosion of the metallic anode.

In the case of Li-ion batteries, the SEI-layer comprises, and substantially consists of, reduction products of the carbonate-based electrolyte.

In the case of Li-S batteries, the materials moving from the cathode to the electrolyte mostly comprise electrochemical reduction products originating from the sulphur cathode in the form of polysulphides. The polysulphides are highly reactive and render the SEI-layer in Li-S batteries and battery cells less effective, up to even ineffective, and thus unstable, which often results in corrosion of the lithium anode. The reaction of the polysulphides can lead to the so-called polysulphide shuttling and consumption of the electrolyte. This leads in most cases to a decrease of the Coulombic efficiency of the Li-S battery.

Further, during charging and discharging, in particular repeated charging and discharging, of a battery cell comprising an alkali metal or alkaline earth metal-based anode, non-uniform dissolution and deposition of the respective metal on the electrode surface, in particular the anode, leads to the formation of needle-like deposits, i.e. (needle-like) dendrites. When a battery separator is provided between the anode and the cathode of the battery cell, these needle-like deposits can penetrate the battery separator material, thereby increasing the risk of short circuiting of the battery cell, reducing the safety of the battery cell.

It is known in the state of the art that the above-mentioned problem of unstable SEI-layers, especially in Li-S batteries, can be reduced significantly by the presence of alkali metal nitrate, such as lithium nitrate (LiNOa) in the electrolyte of the battery cell.

An alternative solution is the provision of a protective layer on the surface of the electrode. Known suitable materials for use as a protective layer include inorganic materials, such as Li₃PO₄, carbon-based materials and Al₂O₃, and organic materials, in particular polymers, such as polyethylene oxide (PEO) and ionomers (polymers having ionic properties), for example sulfonated tetrafluoroethylene based fluoropolymer-copolymers, for example Nation^{™} (CAS 31175-20-9). Although those materials can suppress lithium dendrite growth to some extent, they show several drawbacks, such as a complex preparation process, a low mechanical strength and/or a low Li-ion conductivity. Further, when organic materials are used, a higher operational temperature is required as well in order to provide for sufficient Li-ion conductivity. For example, PEO and Nation^{™} require an operational temperature of about 60°C.

'A compact inorganic layer for robust anode protection in lithium-sulfur batteries', Yu-Xing Yao, Xue-Qiang Zhang et al., InfoMat., 2, pages 379-388 (2020) discloses a wet chemical method wherein a lithium nitrate (LiNOa) layer is deposited on lithium metal by drop-casting an ionic liquid comprising an NO₃⁻ ion. The ionic liquid further comprises a [(FSO₂)₂N]⁻ anion (so-called "FSI-anion"), which reacts with the lithium metal to form a LiF-rich SEI-component in addition to LiNOa. Further, the LiNOa layer is converted into a lithium nitride (Li₃N) layer.

EP 3 136 475 discloses a lithium metal battery comprising a lithium metal anode, a protective layer disposed on the lithium metal anode, a cathode and an electrolyte comprising an organic solvent. The protective layer comprises a polymer, one or more metal salts comprising a Group 1 or a Group 2 element, and a nitrogen-comprising additive. The metal salt and the nitrogen-comprising additive are insoluble in the organic solvent of the electrolyte. The nitrogen-comprising additive can be, amongst others, an inorganic nitrate such as LiNOa, an organic nitrate, an inorganic nitrite, an organic nitrite, or lithium nitride (Li₃N). The protective layer is deposited by combining the metal salt(s) and the nitrogen-comprising additive with the organic solvent to form a protective layer-forming composition, which is applied to the lithium metal anode, followed by drying to form the protective layer.

Wet chemical methods to deposit a protective layer on a substrate of an alkali metal or alkali metal alloy have the disadvantage that the liquids used comprise multiple compounds making it difficult to obtain protective layers of sufficiently high purity. Further disadvantages of wet chemical methods are the risk of reaction of the Li metal, contaminations in the formed protective layer, e.g. unwanted side-products, due to contaminations present in the liquid, long post-treatment time to eliminate the solvent, and a more difficult control of the continuity, homogeneity and uniform thickness of the protective layer upon formation.

US2020/0071835 discloses an article for use as electrode, e.g. anode, in a battery. The article comprises an alkali metal layer and a passivation layer in direct contact with the alkali metal layer. The passivation layer comprises an alkali metal salt and has a thickness of at least 50 nm. The alkali metal salt can be an alkali metal fluoride, such as LiF, or an alkali metal oxide, such as Li₂O. Preferably, the molar percentage of the alkali metal salt in the passivation layer is at least 85 mol.%. The passivation layer is formed by reacting the substrate comprising one or more alkali metals with a gas comprising NO, N₂O, NF₃, SF₆, N₂, O₂ and/or mixtures thereof. The reaction is performed at a temperature between 20 °C and 300 °C, and preferably at a temperature equal to or a slightly below the melting temperature of the alkali metal to increase the reactivity between the alkali metal layer and the gas. For example, the melting temperature of lithium metal is around 180°C in atmospheric conditions. The passivation layers were obtained after a reaction time of minimum 1 hour.

WO2022136699 discloses a method for applying a protective layer on at least part of an exposed alkali metal or alkali metal alloy surface of a substrate, the method comprising the steps of activating a gas comprising a nitrogen-comprising compound by means of a plasma discharge, to obtain an activated gas, and contacting the exposed surface with the activated gas. A protective layer comprising LiNOa is formed on at least part of the exposed surface.

"Plasma grown fluoride-rich artificial SEI for stabilizing Li metal anodes", Zhou et al., Journal of alloys and compounds 935 (2023) 168081, discloses a method for growing a stable fluoride-rich artificial stable solid electrolyte interface on a lithium substrate using a carbon tetrafluoride (CF4) plasma. Lithium disks are placed in a plasma reactor. After pumping the reactor for a low background pressure, high purity CF4 gas is introduced in the reactor and the plasma is ignited. The Lithium disks are treated by the CF4 plasma for a preferable processing time of 25 minutes. From a high resolution XPS spectra of the F1s area it appears that the treated Lithium surface contains LiF and carbon fluorine bonds (C-F), with a higher intensity of carbon fluorine bonds relative to Li-F bonds.

There is a need for new methods for providing improved protective layers for alkali-containing metal anodes that may provide additional advantages in the field of batteries.

### Summary of the invention

The present invention aims to provide a protective layer on a substrate, the substrate comprising a metallic element or alloy, in particular an alkali metal and/or an alkaline earth metal, wherein the protective layer is more stable and/or provides improved electrodes or battery performance. It is an aim to provide methods of forming such a protective layer, which, amongst other advantages, are less complex, have a shorter treatment time, and/or provide better process control.

The invention further aims to provide an article, comprising:
- a substrate comprising a metallic element or alloy, in particular an alkali metal and/or an alkaline earth metal, the substrate and;
- a protective layer covering at least part of the surface, in which the protective layer is more stable and/or provides improved electrode or battery performance. It is an aim to provide such an article in which the protective layer, amongst other advantages, has a particular structure or morphology compared to the protective layers of the state of the art and/or has improved properties, in particular for use as an electrode.

According to a first aspect of the invention, there is provided a method for forming a protective layer on at least a surface of a substrate comprising a metallic element or an alloy, in particular an alkali metal and/or an alkaline earth metal as set out in the appended claims. The method comprises the steps of :
- providing a substrate comprising an alkali metal and/or an alkaline earth metal in a process chamber comprising a non-oxidative atmosphere;
- providing a cold plasma in the process chamber;
- introducing a precursor in the cold plasma to create reactive precursors in the cold plasma;
- exposing at least a part of the surface of the alkali metal-containing substrate to the reactive precursors such as to form a protective layer on the substrate.

According to the present invention, a surface of the substrate is contacted with reactive precursors, which can be free radicals of the precursors or ionized precursors, also referred herein as "activated precursor" and generated by a cold plasma. The gas utilized for igniting the plasma, also referred herein as "carrier gas" is generally Argon (Ar) or nitrogen (N2) or a combination thereof. The cold plasma contains reactive species, e.g. ionized gas, which react with the precursor introduced in the cold plasma to give reactive precursors (also referred as activated precursors) that reacts at least with the surface of the substrate and/or deposit on the surface to form the protective layer. The term "reactive species" in the context of a plasma refers to ions, neutrals, radicals and photons. In some embodiments, when the carrier gas is nitrogen, reactive species include ionized nitrogen that can react with the substrate. The term "precursor" refers to compounds that are introduced in the cold plasma or afterglow and which are activated by the reactive species to form "reactive precursors" which can be ionized compounds or radicals of said compounds.

In a preferred embodiment of the invention, a surface of a substrate preferably comprised between 10 mm² and 2000 mm², preferably between 100mm² and 1000mm² is exposed to the reactive precursors during a time comprised between 1 second and 10 minutes, preferably between 5 seconds and 5 minutes, more preferably between 10 seconds and 2 minutes.

In one embodiment, the precursor is selected from a polymerizable halide containing-monomers such as a halide-containing acrylate and, a halide-containing methacrylate ; or a compound having one of the formulae :

CXR₁R₂R₃ ;

CXR₁=CR₂R₃ ;

CX≡CR₁ ;

SX₆,

wherein X is a halide,
R1, R2, R3 when present are selected among H, X, CH₃, C₂H₅, C₂XₐH₅₋ₐ, wherein a = 1 to 5, CX_{b}H_{3-b}, wherein b = 1 to 3;
or a combination thereof.

Preferably, the precursor has the formulae as represented here below: 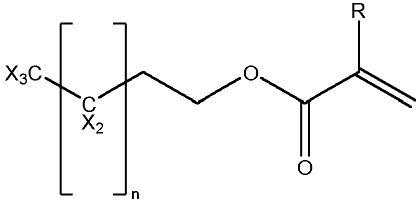
wherein X is F, Cl, Br, I;
R is H or CH3; and
n is comprised between 0 and 20, preferably between 1 and 10, more preferably between 4 and 7.

Preferably, the cold plasma is a plasma afterglow obtained from a plasma jet system comprising a plasma outlet for providing a plasma afterglow directed towards the substate, and wherein the precursor is in a gaseous state or sprayed or in nebulized form and is introduced in the plasma afterglow through a nozzle opening into the plasma afterglow.

Preferably, the surface of the substrate exposed to the reactive precursor is at a distance from the nozzle comprised between 0.5 mm and 30 cm, preferably between 1 mm and 20 cm.

Preferably, the plasma is obtained from exciting a carrier gas selected from argon or nitrogen or helium.

In one embodiment, the gaseous or sprayed precursor is injected in the plasma afterglow with a volume flow rate of 0.1 to 20 slm (standard litre / minute) with a volume flow ratio of precursor to carrier gas comprised between 0.5:100, preferably 0.5:80, preferably 0.5: 60, more preferably 0.5:20 in some embodiments 1:1.

Preferably, the method further comprises a step of purging the process chamber with the carrier gas before ignition of the plasma.

By contacting the surface of the substrate with a halide containing reactive precursor, preferably a fluorinated reactive precursor, generated by a cold plasma, i.e. a plasma remote from the plasma source, hence without exposing the surface directly to the plasma discharge (i.e. the surface is arranged in an afterglow and hence remote from the plasma discharge), it is possible to obtain a halide-containing protective layer on the surface of the substrate. It has been observed that such a protective layer, when used in an electrode for a battery (cell), provides a more stable interface between the metal anode and the electrolyte and a more uniform electrical field with a low activation barrier for metal ion diffusion. More advantageously, such a protective layer provides a high contact angle with electrolytes in use within alkali battery cells, which indicates a hydrophobic behaviour that can be beneficial for the long-term stability of anode against moisture.

Advantageously, the surface of the substrate is contacted with reactive precursors at a temperature equal to or lower than 180°C, more preferably equal to or lower than 120°C, most preferably equal to or lower than 100°C, in particular equal to or lower than 75°C.

More advantageously, the method according to the invention can be operated at atmospheric pressure or near atmospheric pressure.

According to a second aspect of the invention, there is provided an article as set out in the appended claims. The article is preferably obtained from the method described above. The article as described herein comprises a substrate and a protective layer covering at least part of the substrate. The protective layer is conductive to ions of the corresponding metallic element.

The article comprises:
- a substrate comprising a metallic element or alloy, in particular an alkali metal and/or an alkaline earth metal and;
- a protective layer covering at least partially the surface of the substrate and comprising a halide content of at least 5 mol%, preferably of at least 10 mol%, more preferably at least 20 mol%, preferably at most 60 mol%, more preferably at most 50mol%, more preferably at most 40 mol% with respect to the total surface of the protective layer, measured by X ray photoelectron spectroscopy (XPS).

Preferably, wherein the protective layer has a thickness comprised between 1 nm and 1 µm, preferably between 1 nm and 500 nm, more preferably between 1 nm and 100 nm, more preferably between 10 nm and 50 nm, even more preferably between 10 nm and 30 nm, measured by scanning electron microscopy (SEM) coupled with Energy dispersive X ray (EDX) analysis.

Preferably, the surface of the protective layer presents a higher amount of alkali metal and/or an alkaline earth metal-halide bonds relative to carbon-halide bonds, measured by XPS, determined by XPS.

Preferably, the protective layer is characterized by a contact angle with an LP30 electrolyte of at least 80°, preferably at least 85°.

According to a third aspect of the invention, there is provided the use of the article as described herein as an anode in a battery cell.

In a fourth aspect of the invention, there is provided an electrochemical cell comprising the article as described herein as an anode, wherein electrochemical cell, or battery, has a charge-discharge profile showing a polarization given by the potential difference between the charge and discharge plateau of 300 mV or less after 100 cycles at 0.1 C rate. It is admitted that 1C = 1672 mAh/g.

Preferably, the electrochemical cell or battery has a specific capacity after 100 cycles of constant-current charging-discharging at 0.1 C rate that remains over 500 mAh/g.

Advantages the method according to the invention are that the parameters of the protective layer formation process can be controlled more accurately, with a better control of the composition of the obtained protective layer and/or a reduction of the formation of any unwanted by-products, and/or that the process can be carried out at a relatively low temperature such as for example room temperature. Advantageously, the method according to the invention can be realized at atmospheric pressure or close to atmospheric pressure. A further advantage is that plasma-based methods are more efficient in utilizing resources, such as energy.

The protective layer according to aspects of the present disclosure was found to have one or more of the following advantages:
- the protective layer is formed at the surface of the substrate, can be limited to the substrate surface and does not extend into the bulk of the substrate,
- the protective layer shows an improved stability at repeated plating and stripping cycles or charging and discharging cycles (thanks to the improved homogeneity of the electric field by the layer),
- improvement of the charging-discharging efficiency (Coulombic efficiency), in particular in the long-term use,
- improvement of the mechanical stability of the protective layer,
- improvement of the flexibility of the protective layer, and
- improvement of the interface between the substrate and the electrolyte, since the lithium being a strong reducing agent that is easily oxidized and highly reactive, parasitic reactions can be prevented thanks to a protective layer having a high hydrophobicity and water repellent properties, which can be particularly interesting for solid state batteries.

### Brief description of the figures

Aspects of the invention will now be described in more detail with reference to the appended drawings, wherein same reference numerals illustrate same features and wherein:
Figure 1a represents schematically a plasma discharge equipment that can be used in the present invention, with the process chamber positioned in a protective environment. Figure 1b is a schematic representation of a plasma discharge equipment positioned in a protective chamber, that can be used in the present invention.
Figure 2 represents schematically an article of the present invention.
Figure 3 represents schematic expanded view of a layout of a battery cell.
Figure 4a-4d represent different SEM view of a surface of a lithium substrate at different times of treatment according to the method of the present invention.
Figure 5 shows an EDX spectra of a surface of a lithium substrate treated according to a first embodiment of the method of the present invention.
Figure 6 shows an XPS spectra of a surface of a lithium substrate treated according to the method of the present invention and of an untreated surface of a lithium substrate.
Figure 7 shows an XPS spectra in the region F1s of a surface of a lithium surface treated according to the method of the present invention.
Figure 8 shows photographs of drops of electrolytes on a surface of untreated lithium substrate and on surface of lithium substrate treated according to the method of the present invention.
Figure 9a shows a comparison of the charge-discharge profiles after 1 cycle for a reference battery cell and for a battery cell comprising the anode obtained according to the process of the present invention.
Figure 9b shows a comparison of the charge-discharge profiles after 100 cycles for a reference battery cell and for a battery cell comprising the anode obtained according to the process of the present invention.
Figure 10 shows Nyquist plots of the impedance data for symmetrical battery cells comprising protected electrodes obtained by varying the treatment duration according to the invention.
Figure 11 shows potential values measured in function of time for a reference symmetric battery cell (Li | Li) and for a symmetric battery cell comprising protected electrodes according to the invention.
Figure 12 shows an EDX spectra of a surface of a lithium substrate treated according to a second embodiment of the method of the present invention.
Figure 13 shows a comparison of specific discharge capacity profiles of a reference battery cell, of a battery cell comprising an anode obtained according to a first embodiment of the present invention and of a battery cell comprising an anode obtained according to a second embodiment of the present invention.

### Description of embodiments

According to a first aspect, the present invention is related to a method of forming a protective layer on a surface of a substrate. The substrate comprises or consists of a metallic element and/or an alloy of the metallic element. The substrate can comprise two or more metallic elements and/or two or more alloys of a metallic element. The metallic element is an alkali metal or an alkaline earth metal. The obtained protective layer comprises halides compounds, preferably fluoride compounds.

The alkali metal can be any element from Group 1 (Ia) of the periodic system of elements (PSE), i.e. lithium (Li), sodium (Na), potassium (K), rubidium (Rb), cesium (Cs) or francium (Fr). Preferably, the alkali metal is lithium (Li). The alkali metal can however also be sodium (Na).

The surface of the substrate can comprise an alloy of the alkali metal. Preferably, the alkali metal alloy comprises lithium (Li), for example at least 5 wt.% lithium, preferably at least 10 wt.% lithium based on the total weight of the alkali metal alloy, and/or sodium (Na), for example at least 5 wt.% sodium, such as at least 10 wt.%, at least 15 wt.%, at least 20 wt.%, at least 25 wt.%, preferably at least 30 wt.% sodium based on the total weight of the alkali metal alloy. The alkali metal alloy can further comprise one or more other elements, such as elements from Group 2 of the PSE, for example magnesium (Mg), and/or elements from Group 3 of the PSE, for example aluminium (Al), and/or elements from Group 4 of the PSE, for example silicium (Si).

The alkaline earth metal can be any element from group 2 (IIa) of the periodic system of elements (PSE), in particular beryllium (Be), magnesium (Mg), calcium (Ca), strontium (Sr) and barium (Ba). Preferably, the alkaline earth metal is magnesium (Mg).

The surface can comprise an alloy of the alkaline earth metal. Preferably, the alkaline earth metal alloy comprises magnesium (Mg), for example at least 5 wt.% magnesium, such as at least 10 wt.%, at least 15 wt.%, at least 17 wt.%, at least 20 wt.%, at least 25 wt.%, at least 30 wt.%, preferably at least 34 wt.%, such as at least 35 wt.% magnesium based on the total weight of the alkaline earth metal alloy. The alkaline earth metal alloy can further comprise one or more other elements, such as elements from Group 1 of the PSE, for example lithium (Li) or sodium (Na), and/or elements from Group 3 of the PSE, for example aluminium (Al), and/or elements from Group 4 of the PSE, for example silicium (Si).

In a preferred embodiment, the substrate comprises lithium and/or sodium, preferably in their metallic form.

According to the present invention, the protective layer is formed on a surface of the substrate that is exposed to reactive precursors activated by a cold plasma.

The method according to the invention allows forming a protective layer on at least a part of a surface of a substrate comprising a metallic element or an alloy, in particular an alkali metal and/or an alkaline earth metal. The method according to the invention comprises the steps of :
- providing a substrate comprising an alkali metal and/or an alkaline earth metal in a process chamber comprising a non-oxidative atmosphere;
- providing a cold plasma in the process chamber;
- introducing a precursor in the cold plasma to create reactive precursors in the cold plasma;
- exposing at least a part of the surface of the alkali metal-containing substrate to the reactive precursors such as to form a protective layer on the substrate.

The cold plasma is generated by activating a carrier gas by means of a plasma discharge. The cold plasma is preferably remote from the plasma discharge.

An atmospheric pressure plasma discharge can be obtained by means of a direct current (DC) excitation (DC plasma discharge) or an alternating current (AC) excitation (AC plasma discharge), by inductively coupled plasma excitation, by excitation by means of radio waves or microwaves (radio frequency or microwave plasma discharge), or by other excitation means known in the field. Without being limited thereto, an atmospheric pressure plasma discharge by means of DC excitation can be an electric arc discharge (arc plasma discharge). An atmospheric pressure plasma discharge by means of AC excitation can be, without being limited thereto, a corona discharge, a dielectric barrier discharge (DBD), a piezoelectric direct discharge, or a plasma jet.

The term "cold plasma" or "nonthermal plasma" refers to a plasma with heavy species (neutral particles and ions) having temperatures close to room temperature (e.g. 20°C to 100°C) while electronic temperatures can be much higher (superior to 5000°C). Cold plasma includes beams of cold plasma or plasma jet or plasma afterglow that can be obtained from systems such as dielectric barrier discharge or dielectric barrier electrode. Cold plasma such as plasma jet or plasma afterglow can be advantageously used at room temperature or relatively low temperature, ranging from 0°C to 200°C, preferably from 20°C to 180°C, more preferably below 100°C, even more preferably at room temperature (15°C to 30°C) and a under atmospheric pressure or near atmospheric pressure, for example between 0.75 bar and 1.5 bar, more preferably between 0.9 bar and 1.2 bar.

A precursor is introduced in the cold plasma, preferably a plasma afterglow, to form reactive precursors. Reactive precursors may be for example free radicals of precursors or ionized precursors. The surface of the substrate is brought in contact with the reactive precursors which react with the metallic element on the exposed surface and thereby produce the protective layer.

A "plasma afterglow" refers to an activated gas that egresses from the atmospheric pressure plasma discharge, i.e. egressing from a plasma discharge chamber. In other words, an afterglow is located remote from the plasma discharge chamber.

An afterglow plasma treatment, or in other words a plasma treatment at a position remote from the plasma discharge, is considered a 'mild' treatment compared to direct exposure to the atmospheric pressure plasma discharge as the reactive species lose much of their energy before reaching the sample. This allows to control the reaction depth of the substrate with the reactive species and/or with activated precursors, which may be limited to a surface or surface region of the substrate and modification of the bulk of the substrate may be reduced to a minimum or even be avoided. With such a milder treatment also the risk of overheating and unwanted modification of the substrate surface prior to or in the course of its reaction with the reactive species of the plasma afterglow and/or the activated precursors, may be better controlled.

The exposed surface of the substrate is advantageously contacted with the reactive precursor for a total treatment time of between 0.1 seconds and 10 minutes, preferably between 1 second and 5 minutes, preferably between 2 seconds and 4.5 minutes, preferably between 5 seconds and 4 minutes, preferably between 10 seconds and 3.5 minutes, preferably between 15 seconds and 3 minutes, preferably between 20 seconds and 2.5 minutes, for example between 25 seconds and 2 minutes, more preferably between 30 seconds and 90 seconds, such as around 60 seconds. The total treatment time can refer to the time in a single pass or a multi-pass treatment during which a unit surface area is contacted by the reactive precursors.

The treatment time depends on, without being limited thereto, the thickness of the protective layer to be obtained, the composition of the gas, the precursor, the gas flow, the configuration of the plasma discharge equipment (such as distance between electrodes, if electrodes are present), and the type of plasma discharge (AC or DC or other, pulsed wave or continuous wave, etc.), the plasma discharge power, or the temperature of the exposed surface comprising the metallic element or an alloy thereof. The treatment time is advantageously selected such that reaction with the reactive precursor present in the cold plasma remains limited to the substrate surface in such a way that a protective layer of a desired thickness may be formed on the substrate surface and that reaction of the bulk of the substrate may be reduced to a minimum or may even be avoided.

A pre-treatment can be performed to the substrate, in particular to the surface that will be exposed to the reactive precursor present in the afterglow. The pre-treatment can for example comprise one or more of a reductive pre-treatment or a cleaning to remove hydrocarbon or oxidized metals (argon plasma pretreatment, optionally in combination with physical pretreatment such as brushing the surface of the substrate). The pre-treatment can be performed by means of a plasma discharge, or by means of another method, such as a method using one or more liquids. It will however be appreciated that methods as described herein do not necessarily require a pre-treatment of the exposed surface prior to applying the protective layer.

A post-treatment can be performed to the protective layer, in particular a thermal post-treatment, such as a drying step.

The precursor introduced in the cold plasma is selected from a polymerizable halide containing-monomers such as a halide-containing acrylate and, a halide-containing methacrylate ; or a compound having one of the formulae :

CXR₁R₂R₃ ;

CXR₁=CR₂R₃ ;

CX≡CR₁ ;

SX₆,

wherein X is a halide,
R₁, R₂, R₃ when present are selected among H, X, CH₃, C₂H₅, C₂XₐH₅₋ₐ, wherein a = 1 to 5, CX_{b}H_{3-b}, wherein b = 1 to 3;
or a combination thereof.

Preferably, the precursor is polymerizable halide containing-monomers such as a halide-containing acrylate and, a halide-containing methacrylate one or more of the formulae as represented here below: 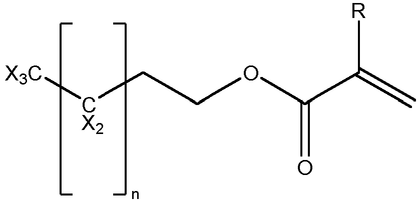
wherein X is a halogen, preferably F, Cl, Br, I, more preferably F;
R is H or CH3; and
n is comprised between 0 and 20, preferably between 1 and 10, more preferably between 4 and 7.

Preferably, the cold plasma is a plasma afterglow obtained from a plasma jet system comprising a plasma outlet for providing a plasma afterglow directed towards the substate, and wherein the precursor is in a gaseous state or in a sprayed or nebulized form and is introduced in the plasma afterglow through a nozzle opening into the plasma afterglow.

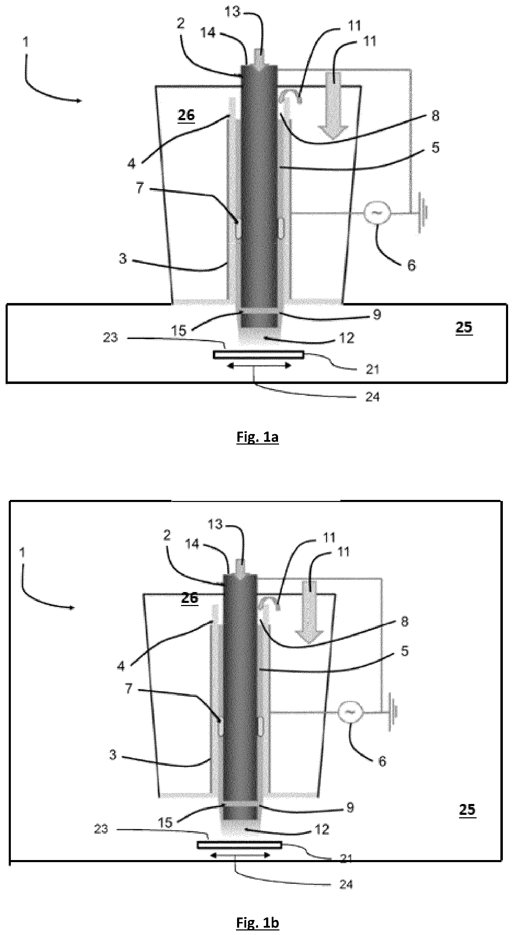

Referring to Fig. 1, an atmospheric pressure plasma jet apparatus 1 can be utilized for carrying out an exemplary embodiment of the method of the invention. The apparatus 1 allows to obtain an atmospheric pressure plasma discharge by a dielectric barrier discharge (DBD). The apparatus 1 advantageously comprises a first electrode 2 and a second electrode 3 included in a plasma discharge chamber 26. The second electrode 3 can be arranged coaxial with the first electrode 2. By way of example, the first electrode 2 is arranged centrally and the second electrode 3 can be arranged to surround the first electrode 2 and being coaxial with the first electrode 2. An electrical insulator 4 is coaxially disposed between the first, central electrode 2 and the second, outer electrode 3. A discharge lumen 5 in which a plasma discharge occurs is provided between the electrical insulator 4 and the first electrode 2. In this case the second electrode 3 acts as a high voltage electrode, and the first electrode 2 can be grounded. Alternatively, the discharge lumen 5 is provided between the electrical insulator 4 and the second electrode, and the first electrode 2 can be the high voltage electrode. The high voltage (HV) electrode refers to the electrode connected to a radio frequency power supply 6 as known in the art. It will be appreciated that the first and second electrodes can alternatively have a planar configuration, or any other suitable configuration, such as elliptical, with the electrical insulator interposed between them and spaced apart from one of the electrodes to define the discharge lumen.

The electrical insulator 4 may be a dielectric medium, such as Al₂O₃. Advantageously, a spacing between an outer surface of the first electrode 2 (or of the second electrode 3) and an inner surface of the electrical insulator 4 defining the discharge lumen 5 is between 0.1 mm and 10 mm, such as between 1 and 5 mm, preferably around 1.5 mm. The distance can be controlled by ceramic spacers 7. The discharge lumen 5 extends between a distal end 8 and a proximal end 9, forming an outlet.

A supply opening disposed at the distal end 8 of the discharge lumen 5 allows for supplying a carrier gas 11 to the discharge lumen 5. The carrier gas is advantageously an inert gas, such as nitrogen, helium or argon, or a combination of two or more thereof. Preferably, the carrier gas 11 is firstly introduced in a plasma discharge chamber 26 surrounding the second electrode 3, preferably cooling the second electrode 3. When the power supply 6 is operated, a plasma discharge is made to occur in the discharge lumen 5, which excites the carrier gas 11 in the discharge lumen 5. The plasma-excited carrier gas leaves the discharge lumen 5 at the proximal end 9, and enters into a process chamber 25. The afterglow zone 12 is formed in a region adjacent to but remote from, i.e. at a distance from, and/or downstream of the proximal end 9.

The power supply 6 is preferably arranged to provide an AC or DC voltage, between 0.5 kV and 50 kV, such as between 1 kV and 10 kV. The voltage may be applied to either one, or both of the first and second electrodes by the power source as a continuous wave, i.e. the plasma discharge may be a continuous wave discharge. Alternatively, the voltage may be applied to either one, or both of the first and second electrodes by the power supply as a pulsed wave, i.e. the plasma discharge may be a pulsed plasma discharge.

The frequency of the voltage applied by the power supply may be from kHz to GHz, for example 18 kHz or 13.56 MHz.

According to an aspect of the present invention, the exposed surface of the substrate is contacted subsequent to activating the gas by the atmospheric pressure plasma discharge in a so-called indirect plasma treatment, remote plasma treatment, or afterglow plasma treatment. Thereby, the surface to be treated is kept remote from the discharge lumen 5.

A precursor 13, in gaseous, vapour or aerosol (sprayed) form, is introduced through a supply opening 14, either directly into the plasma discharge chamber (discharge lumen 5), or into the afterglow zone 12. Preferably, the precursor 13 is introduced in the afterglow zone 12. By way of example, the central, first electrode 2 is hollow having an internal lumen. The precursor 13 is introduced through the internal lumen of the grounded electrode 2 and egresses in the afterglow zone 12, where it is activated by the plasma-excited carrier gas to form a reactive precursor. Subsequently, the reactive precursor reacts at least partially with the exposed surface of a substrate 21 to be treated and/or with a part of the components of the protective layer in formation.

The central grounded electrode 2 comprises nozzle 15 opening in the process chamber 25 such as to project the precursor 13 in the plasma afterglow zone 12. The nozzle 15 allows to control the supplied amount of precursor 13.

The inventors have found that by contacting the surface of the substrate with the afterglow of the atmospheric pressure plasma discharge, without exposing the surface directly to the plasma discharge, and wherein precursor is introduced in the afterglow, it is possible to obtain a protective layer, which when used in an electrode for a battery (cell), provides a more stable interface between the metal and the electrolyte and an optimal electrical field with a low activation barrier for metal ion diffusion.

In order to minimize the risk of melting of the substrate, the temperature of the exposed surface of the substrate is advantageously maintained below the melting temperature of the metallic element and/or the alloy of the metallic element comprised in the substrate. This is achieved by exposing the substrate surface to a plasma afterglow treatment, and by avoiding direct exposure to the plasma discharge (the plasma discharge chamber). Additionally, or alternatively, this may be achieved by moving the substrate surface relative to the plasma discharge chamber, and thus to the afterglow. The skilled person will be able to select the appropriate temperature taking into account the nature of the metal or metal alloy. Preferably, the temperature of the exposed surface, i.e. during plasma afterglow treatment, is equal to or lower than 200°C, more in particular equal to or lower than 180°C, preferably equal to or lower than 120°C, more preferably equal to or lower than 100°C, in particular equal to or lower than 75°C.

The nozzle 15 has an opening which can be a hole preferably with a diameter of between 0.1 mm and 5 mm, such as between 0.2 mm and 2.5 mm, between 0.25 mm and 1 mm, preferably for the method of the invention around 0.5 mm.

Alternatively, the opening of the nozzle can be a slit preferably having a width of between 0.1 mm and 5 mm, such as between 0.2 mm and 2.5 mm, between 0.25 mm and 1 mm, preferably for the method of the invention around 0.5 mm, and a length slightly superior of 5 % or inferior or equal to one dimension (a length, a width or a diameter) of the substrate. For example, for a substrate being an untreated lithium disk-shaped anode having a diameter of 16 mm, the opening of the nozzle may be designed as a slit having a length of 16 mm, so that the substrate can be conveyed through an afterglow providing a substantially linear exposure of reactive precursor to the substrate. In this example, a protective layer can be formed on the surface of the substrate after only one passage at an appropriated rate through the reactive precursor-containing afterglow. In some embodiments, the length of the opening of the nozzle is shorter than one dimension of the surface of the substrate and the substrate can be conveyed through the afterglow with appropriated displacement until the whole desired surface of the substrate is treated.

In one embodiment of the invention, the precursor exits a nozzle opening in the afterglow wherein the precursor is activated, i.e. wherein free radicals of the precursor are formed, the nozzle opening being designed and positioned relative to the substrate such as to contact a spot of the surface of the substrate. The nozzle opening may have a substantially rounded shape.

In another embodiment of the invention, the precursor exits a nozzle opening in the afterglow wherein the precursor is activated, the nozzle opening being designed and positioned relative to the substrate such that the afterglow contacts the substrate by covering at least a linear portion of the substrate. The nozzle opening may have a substantially linear shape.

The substrate 21 is advantageously provided in a process chamber 25 which is maintained in a non-oxidizing and dry atmosphere to prevent the formation of an oxidating layer at the surface of the substrate. The process chamber 25 is advantageously purged before ignition of the plasma and after introduction of the substrate 21 within the chamber 25. For example the gas utilized for purging the chamber 25 can be the same gas as utilized for the ignition of the plasma or another non-oxidating and dry gas.

The process chamber 25 can comprise a tight opening for coupling the plasma jet apparatus or alternatively, the plasma jet apparatus can be included in the process chamber 25 forming a closed environment, which is advantageously filled with an inert gas, such as nitrogen, helium or argon, or a mixture of two or more thereof. Preferably the closed environment is filled with N₂. The closed environment allows to reduce the presence of unwanted impurities in the afterglow zone.

The substrate 21 can be arranged in the afterglow zone 12 by means of a substrate holder 24, such as a plate or a grid or a tray, whereon or wherein the substrate is placed.

In one embodiment, the exposed surface of the substrate and the plasma jet apparatus 1 (and thereby the afterglow 12) are moved with respect to each other, i.e. relative to one another, during contacting the exposed surface with the activated gas in the afterglow. The substrate holder 24 can be moved/conveyed along at least one direction x, y or z relative to the plasma jet apparatus 1 to apply the plasma treatment to the entire surface. The term "direction x, y or z" refers to three orthogonal directions.

According to one embodiment, the substrate holder 24 and plasma jet apparatus 1 can be moved with respect to each other, in particular the substrate holder and afterglow can be moved with respect to each other. Preferably, the exposed surface is oriented towards the nozzle 15 to ensure an optimal contact with the activated precursor in the afterglow zone 12. Advantageously, the substrate holder 24 can be moved with respect to the plasma jet afterglow in a direction which extends along the substrate surface, for example in a direction which is substantially parallel to the surface (i.e. along a direction in a plane x, y). Alternatively or additionally, and advantageously, the substrate holder can be moved towards and away from the plasma jet afterglow - i.e. the substrate surface can be moved towards and away from the plasma jet afterglow (i.e. along a direction z in the axis of the afterglow).

By moving the exposed surface of the substrate and/or the plasma jet apparatus relative to one another during plasma (afterglow) treatment, a large surface area may be treated while the presence of localised spots of high concentrations of activated gas and/or activated precursor egressing from the plasma jet apparatus and contacting the substrate surface may be better controlled or can be avoided where necessary. Additionally, the temperature of the substrate surface may be better controlled and the risk to unwanted overheating and/or melting at the substrate surface may be minimised. This is of particular importance when the substrate surface comprises a low melting material such as lithium, as melting may locally alter the substrate properties. Also, between subsequent contact times with the activated gas and/or precursor, relaxation of the substrate surface may advantageously take place.

Advantageously, the surface of the substrate and the plasma jet apparatus, and thus the afterglow, are moved with respect to each other (in a direction) along the exposed substrate surface, for example in a direction parallel to the exposed surface. Advantageously, the substrate is moved with respect to the plasma afterglow and the plasma discharge chamber. Alternatively, or additionally, the plasma jet apparatus is moved relative to the substrate surface. This relative movement of the surface and the afterglow permits applying a protective layer to a desired part of the substrate surface, and permits subjecting different parts of the substrate surface to varying intensities of activated gas as a function of time. Alternatively, and according to a further embodiment of this invention, the substrate is moved towards and away from the plasma afterglow, for example in a direction perpendicular to the exposed surface. Advantageously, the surface is contacted with the activated precursor in multiple passes so as to allow better heat dissipation and homogenous coating or surface modification without forming hotspots.

Advantageously, contacting of the surface of the substrate by the activated precursor containing afterglow is realised by moving the substrate relative to the nozzle opening of the plasma jet apparatus at a rate such as to contact the desired part of the surface of the substrate with the afterglow and to form a substantially uniform protective layer over the desired part of the surface of the substrate.

In a preferred embodiment of the invention, an area of the surface of the substrate is scanned by the activated precursor containing afterglow at a rate comprised between 1 mm²/min to 2000 mm²/s, preferably, between 100 mm²/min and 1000 mm²/s, more preferably between 200 mm²/min and 100 mm²/s, more preferably between 1000 mm²/min and 1 mm²/s.

In one embodiment, a surface of a substrate comprised between 10 mm² and 2000 mm², preferably between 100mm² and 1000mm² is exposed to the afterglow at a distance from the afterglow comprised between 0.5 mm and 30 cm, preferably between 1 mm and 20 cm.

In one embodiment, the substrate holder is configured to move the substrate according to one or more direction x, y, z to expose a desired surface of the substrate comprised between 10 mm² and 2000 mm², preferably between 100mm² and 1000mm² to the afterglow during a time comprised between 1 second and 10 minutes, preferably between 5 seconds and 5 minutes, more preferably between 10 seconds and 2 minutes.

Advantageously, contacting the exposed surface with the afterglow comprises alternating time periods of contacting the exposed surface with a higher concentration of free radicals of precursors and time periods of contacting the exposed surface with a lower concentration of free radicals of precursors. These time periods are advantageously low-frequency time periods, e.g. individual time periods having a duration of at least 0.5 s, advantageously at least 1 s, and can be obtained by locally treating the surface with the plasma afterglow intermittently, i.e. repetitively, in multiple passes, or by moving the exposed surface repetitively towards and away from the afterglow, or vice versa. Such a way of processing is referred as "pulse processing" and may be useful for initiating the formation of the protective layer while preventing breakdown of the growing protective layer submitted to reactive plasma conditions.

Advantageously, the surface of the protective layer obtained by methods of the present disclosure comprises halide, preferably fluoride in an amount of at least 5 mol%, preferably at least 10 mol%, more preferably at least 20 mol%, preferably at most 60 mol%, more preferably at most 50mol%, more preferably at most 40 mol% with respect to the total surface of the protective layer, the amount of halide or fluoride is expressed in mol % with respect to the composition of the protective layer, as determined by XPS.

In some embodiments, an oxidizing gas, in particular O₂, may be added in the carrier gas and/or in the nebulized or gaseous precursor to a concentration equal to or lower than 5 vol.%, such as equal to or lower than 1 vol.%, equal to or lower than 0.75 vol.%, preferably equal to or lower than 0.5 vol.%, for example equal to or lower than 0.25 vol.%, equal to or lower than 0.1 vol.%, equal to or lower than 0.075 vol.%, more preferably equal to or lower than 0.05 vol.%, such as equal to or lower than 0.025 vol.%, equal to or lower than 0.01 vol.%, equal to or lower than 0.0075 vol.%, most preferably equal to or lower than 0.005 vol.%.

It is possible to mount the plasma jet apparatus 1 on a table movable along three orthogonal directions x, y, z, and move the apparatus 1 over the exposed surface to be treated. Alternatively or additionally, the substrate can be placed on an table movable along three orthogonal directions x, y, z and moved underneath the plasma jet apparatus 1. By doing so, larger surfaces can be treated, and/or a treatment in multiple passes can be performed.

Advantageously, the surface of the substrate is contacted with the afterglow comprising the reactive precursor in multiple passes. This can be performed by moving the nozzle 15 and/or the surface of the substrate relative to one another in repeating passes. By so doing, it is obtained that a same spot on the surface of the substrate is alternatingly exposed to a higher concentration of the reactive precursor, e.g. when the spot is in closer proximity to the opening of the nozzle 15, and to a lower concentration of the reactive precursor, e.g. when the spot is further away from the nozzle. The number of passes can depend on a number of factors, such as the applied power, the distance between the surface and the nozzle, and the metallic element comprised in the substrate. The number of passes is advantageously between 1 and 10, advantageously between 1 and 8, advantageously between 1 and 5.

According to a second aspect of the present invention, an article, comprising a substrate and a protective layer arranged on at least part of the substrate is provided. The protective layer is advantageously obtained by methods as described herein. The protective layer and the substrate share an interface. The substrate and the interface comprise a metallic element and/or an alloy of the metallic element. The metallic element is an alkali metal or an alkaline earth metal. The metallic element and the substrate are as defined above in relation to the method of the invention. The protective layer advantageously comprises halides, preferably fluorides.

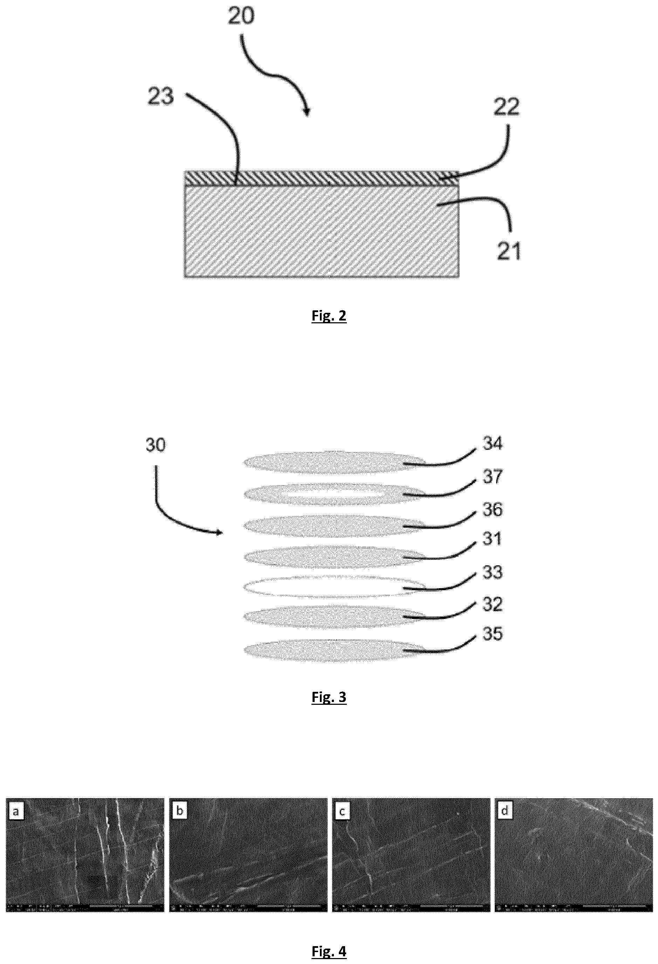

Referring to Fig. 2, an article 20 according to aspects as described herein comprises a substrate 21 and a protective layer 22 arranged thereon. The bulk substrate 21 and the protective layer 22 share an interface 23. Hence, the protective layer is advantageously directly arranged on the substrate 21 at the interface 23, without any other interposed layer between them.

Advantageously, the protective layer is conductive to ions of the metallic element. For example, when the metallic element is lithium (Li), the protective layer advantageously is conductive to lithium ions.

Preferably, the protective layer is impermeable to electrons. Preferably, when the article is used as an electrode, preferably as an anode, in a battery or battery cell, the protective layer is passivated to reactions with the electrolyte. In other words, the protective layer advantageously minimizes reactions between the substrate and the electrolyte.

The thickness of the protective layer can be measured by means of scanning electron microscopy (SEM) of the cross-section of the article. For example, a FEI NovaSEM 450 scanning electron microscope can be used. The cross-section can be made by slicing the article by means of a ceramic knife. The sliced samples can then be positioned on SEM sample holders placed in a transfer module (brand: Kammrath Weiss Gmbh) to avoid any contamination with moisture and oxygen from the atmosphere during transfer to the scanning electron microscope. The SEM imaging is advantageously coupled with Energy Dispersive X-Ray (EDX) analysis in the same electron microscope, by means of a Bruker X Flash 6/60 detector and ESPRIT software.

In some embodiments, the thickness of the protective layer is comprised between 1 nm and 1 µm, preferably between 1 nm and 500nm, preferably between 5 nm and 100 nm, more preferably between 5 nm and 50 nm, more preferably between 5 nm and 30 nm.

Protective layers as described herein were found to be mechanically stable, even when subjecting them to changing electrical fields in the form of repeated plating/stripping cycles, and, when used in an electrode of a battery, in the form of repeated charging/discharging cycles.

The protective layer also provides an improved flexibility/elasticity to the substrate to volume changes upon charging and discharging of the battery compared to prior art protective layers having a different crystallinity and/or morphology, leading to a reduced damage of the protective layer over time.

Advantageously, the protective layer comprises a halide content of at least 5 mol %, preferably at least 10 mol%, more preferably at least 20 mol%, preferably at most 60 mol%, more preferably at most 50mol%, more preferably at most 40 mol% with respect to the total surface of the protective layer, measured by X ray photoelectron spectroscopy (XPS). Preferably, the halides are fluorides.

The article of the invention is advantageously used as an electrode. The electrode is advantageously an anode. The electrode can be used in a battery or a battery cell. Preferably, the electrode is used in the battery cell as an anode. Particularly preferred is a lithium-ion, a solid-state lithium-ion, a Li-S (lithium-sulphur) or a lithium-air battery or battery cell comprising a lithium anode with a protective layer as described herein.

Fig. 3 represents an exemplary embodiment of a battery cell 30. The battery cell 30 has a coin-cell configuration known in the art as a CR2032 type configuration. The battery cell 30 comprises an anode 31 and a cathode 32. The anode 31 is an electrode according to the present invention. The battery cell 30 further comprises a liquid electrolyte (not shown). The battery cell advantageously comprises a battery separator membrane 33 between the anode 31 and the cathode 32. The cathode can for example be a sulphur-based cathode, such as for a Li-S battery cell. The battery cell 30 further comprises a coin cell lid 34, a coin cell base 35, a spacer 36 and a spring 37. The spacer 36 and the spring 37 provide good contact between the other components 31, 32, 33, 34, 35 of the battery cell 30.

The electrolyte may be a solid electrolyte. A solid electrolyte may be a solid polymer or a solid inorganic glass or a composite containing polymer, ceramic and glass components. For example, the solid electrolyte may be poly(ethylene oxide) (PEO) with lithium salts dispersed in the polymer matrix of the PEO.

Alternatively, the electrolyte may be a liquid electrolyte. The electrolyte may be an ionic liquid, optionally comprising an organic component, a salt-solvent mixture, preferably a super-saturated salt-solvent mixture. For example, a liquid electrolyte may be an ionic liquid with lithium salt dissolved therein, or a mixture of an ionic liquid and an organic liquid with a dissolved lithium salt. Examples of liquids that may be used include polyethylene glycol dimethyl ether (PEG DME) or an organic solvent such as dioxolane mixed with dimethyl ether. The liquid electrolyte may comprise a compound of tetraethylene glycol dimethyl ether (PEGDME) and lithium bis(trifluoromethanesulfonyl)imide (LiTFSI). A useful ionic liquid is methyl-butyl pyridinium trifluorosulfonyl imide (PYR14TFSI). In one example, the electrolyte has a 1:1 ratio by weight of PYR14TFSI and PEGDME, with 1 mol/kg LiTFSI. In another example, the electrolyte comprises 1M lithium bis(trifluoromethanesulfonyl)imide (LiTFSI) in dimethoxyethane (DME):1,3-dioxolane (DOL) with a weight ratio of 2:1.

Yet alternatively, the electrolyte may be a gel electrolyte. A gel electrolyte may be a polymer-gelled organic medium. For example, the gel electrolyte may be a mixture of poly(methyl methacrylate) (PMMA), a lithium salt and a small amount of liquid.

The battery separator membrane 33 can be a porous separator membrane. Polymeric battery separator membranes known in the field may be used, such as a porous polypropylene (PP) membrane or a porous polyethylene (PE) membrane. For example, a polypropylene membrane having a thickness of 25 µm and a porosity of 50% may be used. PP and PE are preferred materials because of their chemically inert character. However they are not easily wetted, while it is preferred that the porous separator may absorb the liquid electrolyte. To this end the hydrophobic PP and PE may be treated with a surface treatment or a coating, such as a spray coating, a dip coating or a plasma coating - atmospheric pressure plasma or low pressure plasma. Alternatively, the battery separator membrane may be a ceramic material or made of glass fiber.

### Examples

### Example 1

A lithium metal substrate was treated with a method of the invention. The plasma jet apparatus of Fig. 1 was used, wherein the lithium metal substrate was mounted on a substrate holder 24 and placed in the afterglow zone 12 of an atmospheric pressure dielectric barrier discharge. The substrate holder was moved by means of an XY translation table in a plane parallel to the outlet of the discharge lumen of the plasma jet apparatus so as to expose the entire surface to the afterglow zone. The plasma jet apparatus was mounted in a closed environment as described above. Nitrogen was added to the closed environment to limit the presence of unwanted impurities, in particular oxygen and water vapour. The gas used for the plasma discharge was nitrogen as the plasma gas and carrier gas. The total nominal gas flow of nitrogen carrier gas was of 20 slm (standard liter/minute). Perfluorodecyl acrylate was used as the precursor and was nebulized into the central grounded tube. The precursor was introduced in the plasma afterglow through the nozzle opening with a flow of 2 slm. The nozzle opening had a rounded shape of a diameter of 10 mm and the surface of the substrate was at a distance of 3 mm relative to the nozzle opening. The plasma power was 300 W and the frequency was 70 kHz. The duration of contacting the exposed surface with the activated nitrogen gas and activated precursor was 1 minute (1 pass). The temperature of the exposed surface was around 80°C. The closed environment comprised less than 50 ppm O₂.

Fig. 4A, 4B, 4C, 4D shows SEM-images of the morphologies of the obtained protective layer after a treatment time of (a) 0 seconds, (b) 1 minute, (c) 2 minutes and (d) 5 minutes. Not any significant morphological features are observed.

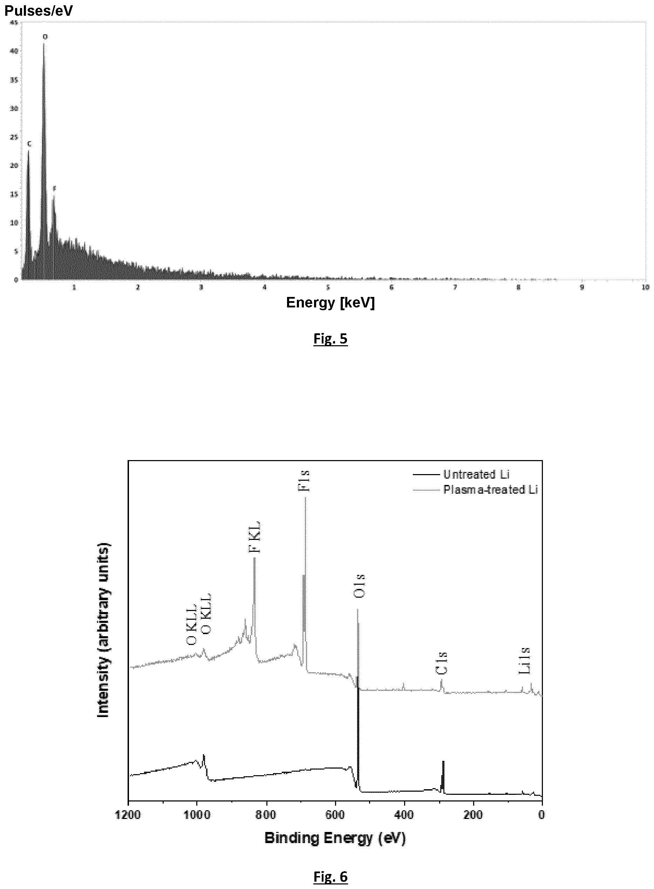

Fig 5 shows an EDX spectra of the protective surface obtained by the process of the present example. The EDX spectra shows the presence of fluoride, carbon and nitrogen.

XPS measurement of samples were performed using Quantes from ULVAC PHI equipped with dual micro focused X-ray beam (Al Kα and Cr Kα 1486.6 and 5414.9 eV). The beam spot sizes had a 100 µm diameter for both sources and the power equal to 25 W and 50 W for Al and Cr, respectively. The take-off angle for photoelectron detection was 45°. All experiments were performed without electron and Ar-ion charge neutralizations enabled under ultrahigh vacuum conditions (p < 10-7 Pa). High-resolution spectra were acquired with a pass energy of 69 eV for both energy sources, corresponding to an energy resolution of about 0.81 and 1.16 eV for Al kα and Cr kα, as estimated from the full width at half maximum (FHWM) of the Ag 3d5/2 of a reference Ag sample. All XPS spectra were analyzed with the Multipack software. The relative Scofield factor (RSF) were exported from the MultiPak library to take in account the transmission function of the spectrometer. Peak fitting was performed with Pseudo-Voigt functions having 30% and 70% of Lorentzian and Gaussian, weight for each component, named GL(30), and standard Shirley backgrounds. Binding energy charge correction was performed using the C1s core level at 2884.8 eV associated to C-C bonds from surface contamination (always present at the surface of the samples).

The samples were transported in air-tight vessel and positioned on a 25 mm sample holder and transferred to the XPS using a dedicated transfer vessel to avoid contamination.

Fig. 6 shows an XPS spectra of an untreated Lithium substrate (the bott curve) and of a treated substrate according to the example. Significantly intense fluorine signals were observed in the X-ray photon spectroscopy. The carbon content was relatively lower, and traces of nitrogen were also present as nitrogen was used as the process gas.

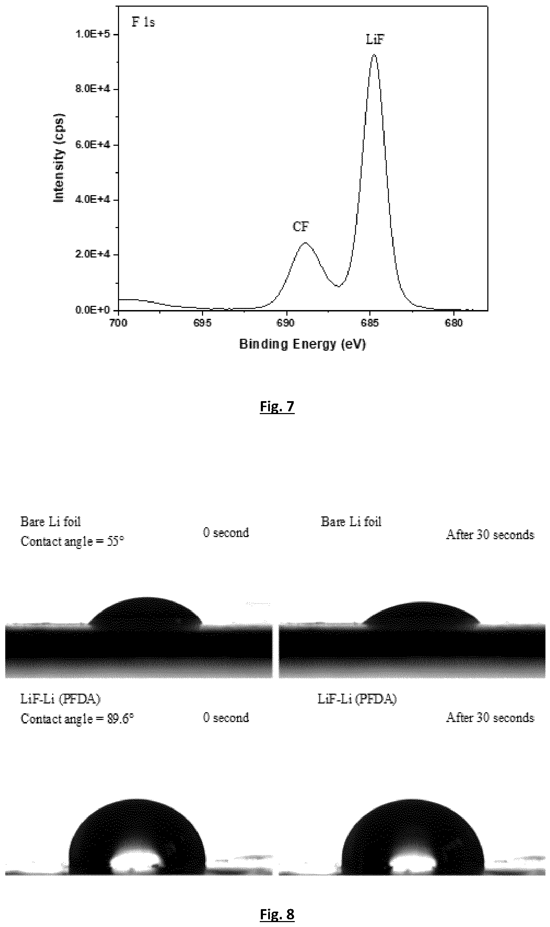

Fig. 7 shows an XPS spectra in the F1s region of the treated substrate according to the example. The spectra shows the presence of Li-F bonds at 684.8 eV and C-F bonds at 686.6 eV on the surface of the protective layer, with a higher amount of Li-F bonds relative to C-F bonds.

Fig. 8 shows the contact angle of untreated lithium substrate and lithium substrate treated according to the process of the example. The wettability of the surface of an untreated Lithium substrate and of the surface of a treated Lithium substrate by an electrolyte were performed with a DataPhysics OCA15 contact angle measurement system with an accuracy of ±0.1° and a resolution of ±0.01°. The static and dynamic contact angles were acquired by depositing symmetric drops (3 µl) of the electrolyte onto the surface of the bare lithium (untreated lithium) and plasma-treated lithium samples. The sessile droplet method was used for measuring the contact angle by fitting the drop shape to an ellipse. The electrolyte used was LP30 electrolyte which is a commercial product comprising 1M lithium hexafluorophosphate (LiPF6) dissolved in ethylene carbonate/dimethyl carbonate (EC:DMC) solution in a ratio of 1 :1 per weight. For the untreated lithium substrate, the contact angle is of 55° and seems to decrease within 30 seconds after the deposit of the drop. For the lithium substrate treated according to the process of the example, the contact angle is of 89.6° and remains stable 30 seconds after depositing of the drop.

### Example 2

A coin-type electrochemical cell was assembled to evaluate the charge/discharge and the cycle life characteristics of an anode made according to the process of example 1. The cell assembly was performed in an atmosphere of dry argon.

Li-S battery cells were made to evaluate the charge/discharge characteristics and the cycle life characteristics of the anode comprising a protective layer. The battery cells were produced in a glovebox filled with argon and with an oxygen and moisture level below 1 ppm to reduce the risk for contamination during production.

Battery cells of the type represented by Fig. 3 were made, in which the anode was an electrode obtained through Example 1. The anode is a lithium metal disc of 16 mm diameter on which the desired passivation layer is formed by plasma treatment. A reference battery cell was made in which the anode was lithium metal without any protective layer. In reference cells, the anode is a Li metal disc of 16 mm used as obtained from commercial vendors. To evaluate the electrochemical properties of the processed lithium metal anode in comparison with reference anodes, batteries are constructed in a coin-cell configuration known in the art as CR2032 type. For both battery cells, the cathode was prepared in-house by coating a slurry containing 66 wt.% of sulphur, 24 wt/% of carbon and 10 wt.% of a polymeric **binder** based on lithiated poly(acrylic acid) (Li-PAA) on an aluminium foil. A polymeric separator was placed between the anode and the cathode. The battery cells were filled with 90 µL of an electrolytic solution comprising 1M lithium bis(trifluoromethanesulfonyl)imide (LiTFSI) in dimethoxyethane (DME)/1,3-dioxolane (DOL) with a weight ratio of 2:1 and without LiNOa additive. The battery cells were sealed with a pneumatic press. In reference cells, the anode is a Li metal disc of 16 mm used as obtained from commercial vendors.

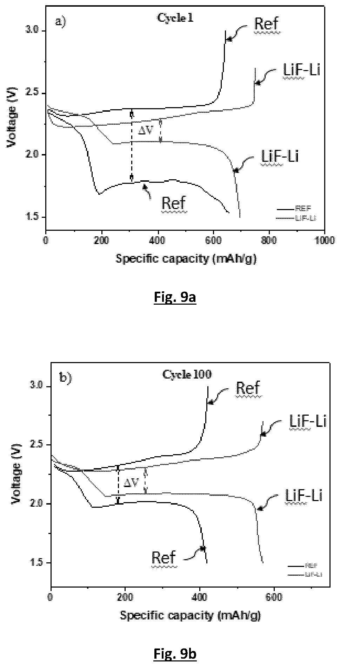

The fig. 9a shows a comparison of the charge-discharge profiles after 1 cycle for a reference battery cell (Ref) and for a battery cell comprising the anode of example 1. The fig. 9b shows a comparison of the charge-discharge profiles after 100 cycles for a reference battery cell (Ref) and for a battery cell comprising the anode of example 1. The polarization (ΔV) given by the potential difference between the charge and discharge plateaus is characteristic of the Li+ transport dynamics. A low ΔV value indicates better Li+ transport and long-term cyclability. From Figures 9a and 9b, it is clear that the polarization is smaller than in the cell with passivated lithium anode than in the reference cell (210 mV in the cell with plasma-treated Li anode after 100 cycles at 0.1 C rate, compared to 340 mV in the cell with bare Li anode).

### Example 3

Li-S symmetric battery cells were made to evaluate how the internal resistance of the anode with and without the protective layer evolves as a function of time. The battery cells were produced in a glovebox filled with argon and with an oxygen and moisture level below 1 ppm to reduce the risk for any contamination during production.

The Li-S symmetric battery cells are similar to the battery cells 30 of Fig. 3, with the difference that both electrodes 31, 32 are identical. A reference symmetric battery cell (LilLi) was made and comprises two electrodes made of lithium metal substrates without any protective layer. Another Li-S symmetric battery cells (LiF-Li|LiF-Li) was made and comprises two electrodes made of lithium metal substrate with the protective layer obtained according to the process of Example 1. In both cells, a polymeric separator 33 was placed between the electrodes 31 and 32. The battery cells 30 were filled with 90 µL of an electrolytic solution comprising 1M lithium bis(trifluoromethanesulfonyl)imide (LiTFSI) in dimethoxyethane (DME)/1,3-dioxolane (DOL) with a weight ratio of 2:1 and without LiNOa additive. Further, a coin cell lid 34 and a coin cell base 35 were provided, as well as a spacer 36 and a spring 37 to ensure good contact between the components of the cell 30.The battery cells 30 were sealed with a pneumatic press.

Electrochemical impedance spectroscopy (EIS) was performed on the symmetrical battery cell comprising protected electrodes according to the invention. A 10 mV AC potential was applied to the cell during the frequency sweep. The frequency sweep was performed from 100 kHz to 0.01 Hz.

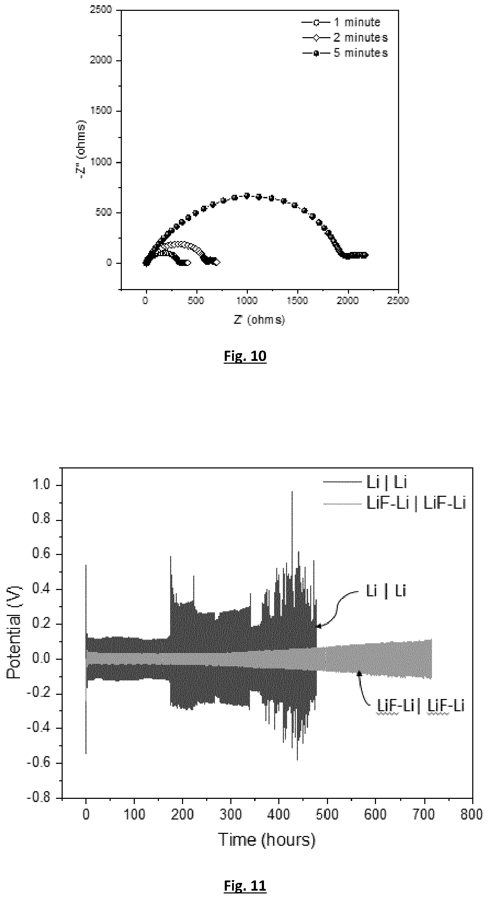

Fig. 10 show a Nyquist plot of the impedance data for the symmetrical battery cell comprising the protected electrode according to the invention. In the Nyquist plots the impedance data from each frequency point is plotted. The abscissa (x-axis) shows the real part of the impedance data and the ordinate (y-axis) shows the imaginary part of the impedance data. The effect of plasma treatment duration on the thickness of the film could be indirectly observed by the proportional increase in the impedance of the symmetric cells with increasing plasma treatment duration. As seen in Figure 10, the impedance due to the surface layer resistance of the electrode treated for a duration of 1 minute is 300 Ω, whereas the impedance increases to about 600 Ω and 2000 Ω when the treatment time is increased to 2 minutes and 5 minutes, respectively.

### Example 4

The symmetric battery cell configuration 30 of example 3 was used to evaluate the lithium plating/stripping behaviour of the electrode by monitoring the evolution of the overpotential over time when a constant current of 1 mA/cm² is applied. An Ametek PARSTAT PMC-200 multichannel potentiostat was used to perform these measurements.

Fig. 11 shows the potential values measured for a duration of almost 500 hours for the reference battery cell (Li | Li) and for a duration of almost 750 hours for the battery cell comprising protected electrodes according to the invention (LiF-Li | LiF-Li). Up to a test duration of around 175 hours, the potential values represent the deterioration of the lithium metal. A higher absolute potential value, and thus a wider fluctuation of the potential values, indicates a larger deterioration. Hence it is clear that the electrode comprising a lithium metal substrate without protective layer shows earlier (from 175 hours test duration on) and more deterioration than the protected electrode of the invention. The electrode of the invention shows no detectable signs of deterioration up to at least almost 750 hours test duration (longer was not tested). The plasma-treated Li anode shows stable Li plating/stripping profile compared to the untreated anode (Figure 11). The significantly lower overpotential of the plasma-treated anode indicates a smooth deposition and dissolution of lithium on the anode surface, and a lower activation barrier for the lithium diffusion. This is facilitated by the Li-F rich protective layer that guides the lithium nucleation and supports a planar growth mechanism rather than a dendritic growth (which is the case in the untreated anode and could be seen by the abrupt increase in the overpotential around 450 hours).

### Example 5

A lithium metal substrate was treated as described in example 1, except that the precursor used was SF₆. The total nominal gas flow of nitrogen carrier gas was 20 slm and the gas flow of SF₆ was 4 slm. The surface of the lithium metal substrate was exposed to the afterglow containing SF₆ for 5 minutes.

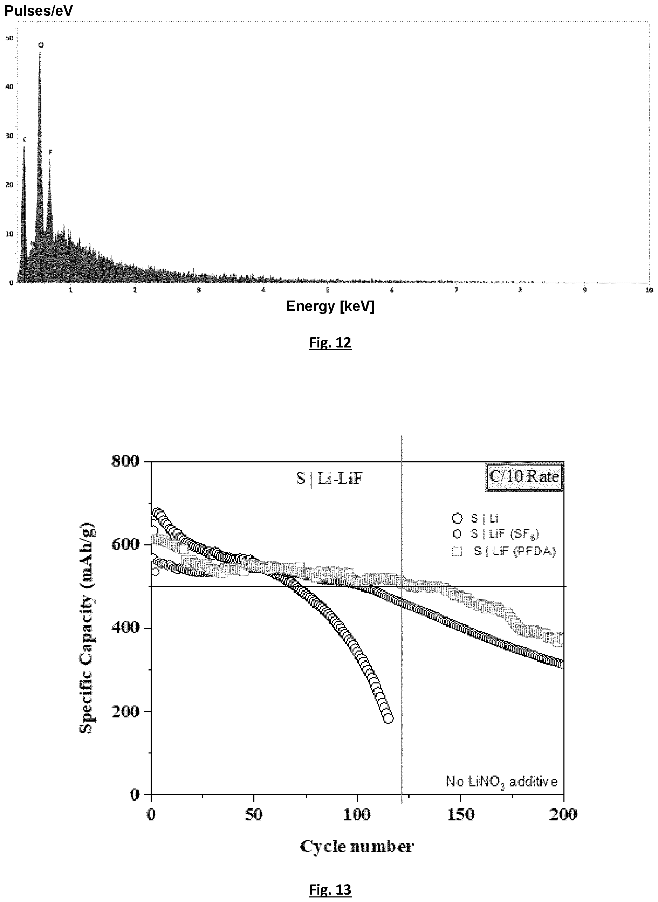

The figure 12 presents an EDX spectra of the surface of the protective layer showing the presence of fluorinated interphase.

### Example 6

Li-S battery cell of the type represented by Fig. 3 was made, in which the anode was an electrode obtained through Example 5. The cathode and the electrolyte were the same as those used in the battery cell of example 2. The fig. 13 shows a comparison of specific discharge capacity profiles of different Li-S cells. The cells assembled with sulphur cathode and bare lithium anode show drastic capacity fading and reach insignificant values by the end of 100 cycles. On the other hand, the cells assembled with the plasma-treated lithium anodes show improved cycling stability. Among the plasma-treated anodes, PFDA-treated anodes show the best capacity retention behavior. The specific capacity of batteries comprising a SF6-treated anode as described in example 5 remains over 500 mAh/g after about 100 cycles. The specific capacity of batteries comprising a PFDA-treated anode as described in example 1 remains over 500 mAh/g after about 120 cycles.

## Claims

1. Method of forming a protective layer on at least a part of a surface of a substrate comprising a metallic element or an alloy, in particular an alkali metal and/or an alkaline earth metal, the method comprising the steps of:
- providing a substrate comprising an alkali metal and/or an alkaline earth metal in a process chamber comprising a non-oxidative atmosphere;
- providing a cold plasma in the process chamber;
- introducing a precursor in the cold plasma to create reactive precursors in the cold plasma;
- exposing at least a part of the surface of the alkali metal-containing substrate to the reactive precursors such as to form a protective layer on the substrate.

2. Method according to claim 1 wherein the surface of the substrate is exposed to the reactive precursors during a time comprised between 1 second and 10 minutes, preferably 2 minutes.

3. Method according to claim 1 or 2 wherein the precursor is selected from one or more compounds selected among:
a polymerizable halide containing-monomer such as a halide-containing acrylate
and, a halide-containing metacrylate, preferably having the formulae; 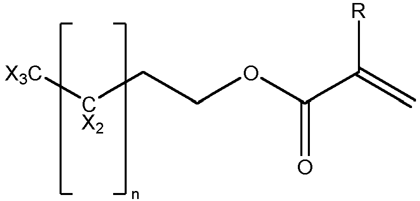
wherein X is F, Cl, Br, I;
R is H or CH3; and
n is comprised between 0 and 20, preferably between 1 and 10, more preferably between 4 and 7 ;
a compound having one of the formulae :
CXR₁R₂R₃ ;
CXR₁=CR₂R₃ ;
CX≡CR₁ ;
SX₆,
wherein R₁, R₂, R₃ when present are selected among H, X, CH₃, C₂H₅, C₂XₐH₅₋ₐ,
wherein a = 1 to 5, CX_{b}H_{3-b}, wherein b = 1 to 3.

4. Method according to any one of the preceding claims wherein the cold plasma is a plasma afterglow obtained from a plasma jet system comprising a plasma outlet for providing a plasma afterglow directed towards the substate, and wherein the precursor in a gaseous state or in a sprayed or nebulized form is introduced in the plasma afterglow through a nozzle opening into the plasma afterglow.

5. Method according to claim 4 wherein the surface of the substrate exposed to the reactive precursor is at a distance from the nozzle comprised between 0.5 mm and 30 cm, preferably between 1 mm and 20 cm.

6. Method according to any one of the preceding claims wherein the plasma is obtained from exciting a carrier gas selected from argon or nitrogen.

7. Method according to any one of the preceding claims wherein the sprayed or gaseous precursor is injected in the plasma afterglow through the nozzle with a flow comprised between 0.1 to 20 slm (standard litre / minute) with a volume flow ratio of precursor to carrier gas comprised between 0.5:100, preferably 0.5:80, preferably 0.5: 60, more preferably 0.5:20 in some embodiments 1:1.

8. Method according to any one of the preceding claims comprising a step of purging the process chamber with the carrier gas before ignition of the plasma.

9. Article comprising :
- a substrate comprising a metallic element or alloy, in particular an alkali metal and/or an alkaline earth metal and,
- a protective layer covering at least partially the surface of the substrate and comprising a halide content of at least 5 mol%, preferably of at least 10 mol%, more preferably at least 20 mol%, preferably at most 60 mol%, more preferably at most 50mol%, more preferably at most 40 mol% with respect to the total surface of the protective layer, measured by X ray photoelectron spectroscopy (XPS).

10. Article according to claim 9 wherein the protective layer has a thickness comprised between 1 nm and 1 µm, preferably between 1 nm and 500 nm, more preferably between 1 nm and 100 nm, more preferably between 10 nm and 50 nm, even more preferably between 10 nm and 30 nm, measured by scanning electron microscopy (SEM) coupled with Energy dispersive X ray (EDX) analysis.

11. Article according to any one of claims 9 or 10 wherein the surface of the protective layer presents a higher amount of alkali metal and/or an alkaline earth metal-halide bonds relative to carbon-halide bonds, measured by XPS.

12. Article according to any one of the claims 9 to 11 wherein the protective layer is **characterized by** a contact angle with an LP30 electrolyte of at least 80°, preferably at least 85°.

13. Use of the article according to any one of the claims 9 to 11 as an anode in a battery cell.

14. Electrochemical cell comprising the article of any one of claims 9 to 12 wherein the polarisation given by the potential difference between the charge and discharge plateau is of 300 mV or less after 100 cycles at 0.1 C rate.

15. Electrochemical cell comprising the article of any one of claims 9 to 12 wherein the specific capacity after 100 cycles of constant-current charging-dicharging at 0.1 C rate remains over 500 mAh/g.
